# EUROPEAN PATENT APPLICATION

(11) **EP 2 472 609 A1**
(43) Date of publication of application: **04.07.2012**
(21) Application number: 11167422.2
(22) Date of filing: 25.05.2011
(51) Int. Cl.: H01L 33/32, H01L 21/02

(54) **Template, method for manufacturing the template and method for manufacturing vertical type nitride-based semiconductor light emitting device using the template**

(30) Priority: 04.01.2011 KR 20110000642
(71) Applicant: Semi-Materials Co., Ltd, Seongnam-si, Gyeonggi-do 463-400 (KR); Park, Kun, Bundang-gu Sengnam-si, Gyeonggi-do 463-440 (KR)
(72) Inventor: Oh, Chung-Seok, 339-764, Chungcheongnam-do (KR); Jang, Sung-Hwan, 445-724, Gyeonggi-do (KR); Jung, Ho-Il, 712-832, Gyeongsangbuk-do (KR); Park, Chi-Kwon, 704-742, Daegu (KR); Park, Kun, Gyeonggi-do 463-440 (KR)
(74) Representative: Müller Schupfner & Partner

(57) **Abstract**

Disclosed is a method for manufacturing a template. The method includes growing a first nitride layer containing a Group-III material on a substrate; forming a plurality of etch barriers having different etching characteristics from the first nitride layer on the first nitride layer; forming a pillar-shaped nano structure by etching the first nitride layer in a pattern of the etch barriers using a chloride-based gas; and forming the nitride buffer layer having a plurality of voids formed therein by growing a second nitride layer on top of the nano structure. A method for manufacturing a nitride-based semiconductor light emitting device using the template is also disclosed.

## Description

### 1. Technical Field

The present invention relates to a technique for manufacturing a nitride-based semiconductor light emitting device using a template.

### 2. Description of the Related Art

Nitride-based semiconductor light emitting devices are in increasing demand because of various advantages thereof, such as long lifespan, low power consumption, excellent initial driving characteristics, high vibration resistance, and the like.

In general, a nitride-based semiconductor light emitting device includes a plurality of nitride layers including an n-type nitride layer, an active layer and a p-type nitride layer. Here, the n-type and p-type nitride layers provide electrons and holes to the active layer, so that light is emitted through recombination of the electrons and holes in the active layer.

However, since a substrate formed of a material such as sapphire (Al₂O₃) generally has a different lattice constant from a nitride layer, severe lattice distortion occurs when the nitride layer is directly grown on the substrate. Accordingly, in recent years, a method for reducing lattice distortion in growth of a nitride layer using a template having an undoped nitride layer deposited on a substrate has been proposed. However, since a dislocation density of 10⁹ to 10¹⁰/cm² is obtained even when using such a method, there is a limitation in improving crystal quality of the nitride layer.

Recently, as a method for reducing dislocation density, a growth technique, for example epitaxial lateral overgrowth (ELO), has been proposed. In this technique, an SiO₂ mask having a pattern is formed on a template having an undoped nitride layer deposited thereon and a nitride layer is then grown from an opening of the mask to induce lateral growth on the mask. However, since the growth technique includes SiO₂ film deposition based on chemical vapor deposition (CVD), resist coating, photolithography, etching and cleaning, and the like, the manufacture process is complicated and takes much time.

### BRIEF SUMMARY

An aspect of the present invention is to provide a method for manufacturing a template and a method for manufacturing a vertical type nitride-based semiconductor light emitting device using the template, in which a nitride buffer layer having a porous structure is formed on a substrate, thereby reducing stress caused by a difference in lattice constant between the substrate and a nitride layer while preventing dislocation.

In accordance with one aspect of the invention, a method for manufacturing a template includes: growing a first nitride layer containing a Group-III material on a substrate; forming a plurality of etch barriers, having different etching characteristics from the first nitride layer, on the first nitride layer; forming a pillar-shaped nano structure by etching the first nitride layer in a pattern of the etch barriers using a chloride-based gas; and forming a nitride buffer layer having a plurality of voids formed therein by growing a second nitride layer on top of the nano structure.

In accordance with another aspect of the invention, a method for fabricating a vertical type nitride-based semiconductor light emitting device includes: growing a buffer layer on a growth substrate, the buffer layer having an etch barrier formed therein; forming a pillar-shaped nano structure by etching the buffer layer in a pattern of the etch barrier using a chloride-based gas; forming a multi-layered nitride layer having a plurality of voids formed therein by growing an n-type nitride layer, an active layer and a p-type nitride layer on top of the nano structure; forming a conductive substrate on top of the multi-layered nitride layer; removing the growth substrate using a portion having the plurality of voids formed therein as a cutting surface; and processing the cutting surface to form an electrode.

### BRIEF DESCRIPTION OF THE DRAWINGS

The above and other aspects, features and advantages of the invention will become apparent from the following description of the following embodiments given in conjunction with the accompanying drawings, in which:
Fig. 1 is a sectional view of a template according to an exemplary embodiment of the present invention;
Fig. 2 is a flowchart of a process of manufacturing the template of Fig. 1;
Fig. 3 is a schematic sectional view explaining the process of manufacturing the template of Fig. 2;
Fig. 4 is a scanning electron microscope (SEM) image showing top surface of a first nitride layer obtained by etching for 15 minutes in a state in which no etch barrier is formed;
Fig. 5 is an SEM image showing a cross section of a first nitride layer obtained by etching for 15 minutes in a state in which etch barriers are formed;
Fig. 6 is a sectional view of a lateral type nitride-based semiconductor manufactured according to an exemplary embodiment of the present invention; and
Fig. 7 is a view schematically illustrating a method for manufacturing a vertical nitride-based light emitting device according to an exemplary embodiment of the present invention.

### DETAILED DESCRIPTION

Exemplary embodiments of the present invention will be described in detail with reference to the accompanying drawings. In the following embodiments, a template used in manufacturing a light emitting device will be mainly described. However, the present invention is not limited thereto and may be applied to various templates used for growth of a nitride.

It will be understood that when an element such as a layer, film, region or substrate is referred to as being "on" another element, it can be directly on the other element or intervening elements may also be present. In contrast, when an element is referred to as being "directly on" another element, there are no intervening elements present.

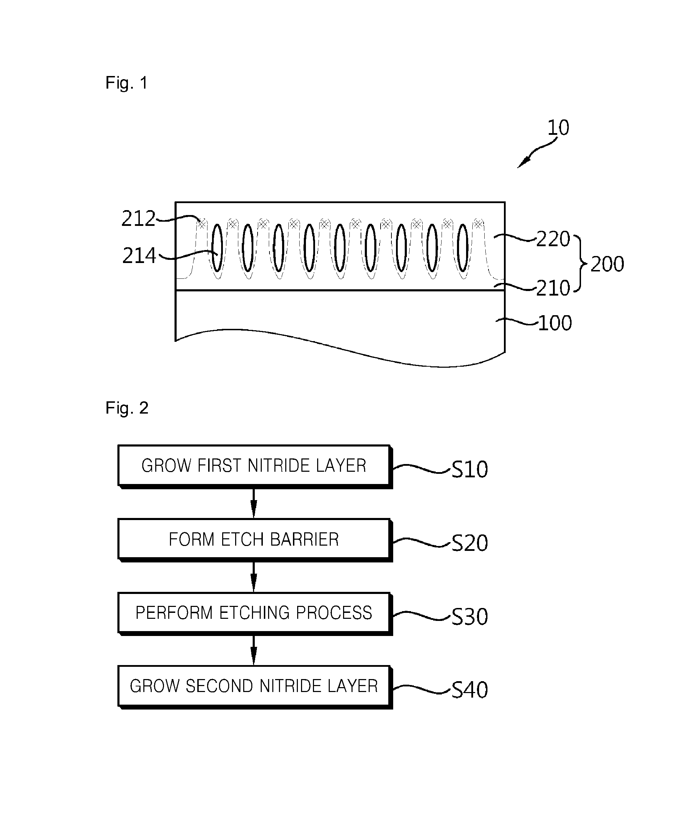

Fig. 1 is a sectional view of a template according to an exemplary embodiment of the present invention.

Referring to Fig. 1, the template 10 according to this embodiment includes a substrate 100 and a nitride buffer layer 200 grown on the substrate 100. The nitride buffer layer 200 has a porous structure which includes a plurality of voids 214 formed therein, and other nitride layers may be grown and stacked on the nitride buffer layer 200.

The substrate 100 defines a base surface on which a nitride layer starts to grow. The substrate 100 is made of a material suitable for lattice growth of the nitride layer. In this embodiment, a sapphire (Al₂O₃) substrate is used as the substrate 100. Here, the sapphire substrate has a hexagonal structure and is stable at high temperature. In addition, a substrate made of a material such as spinel (MgAlO₄), silicon carbide (SiC), silicon (Si), zinc oxide (ZnO), gallium arsenic (AsGa) or gallium nitride (GaN) may be used.

The nitride buffer layer 200 is formed on the sapphire substrate 100. In this embodiment, the nitride buffer layer 200 is configured using a GaN layer having the hexagonal system structure like the sapphire substrate 100. Alternatively, the nitride buffer layer 200 may be configured using a Group-III nitride layer.

As shown in Fig. 1, the nitride buffer layer 200 includes a first nitride layer 210 and a second nitride layer 220, which are made of a GaN material. The first nitride layer 210 is grown on the sapphire substrate 100, and a plurality of nano structures 213 is then formed in an upper portion of the first nitride layer 210 using an anisotropic etching process. The second nitride layer 220 is grown to form a roof structure on top of the nano structures 213, so that the nitride buffer layer 200 having a plurality of voids 214 is formed as shown in Fig. 1.

At this time, a plurality of etch barriers 212 is provided within the nitride buffer layer 200. The etch barrier 212 is a region of the first nitride layer 210 doped with a foreign material, and in the corresponding region, a different lattice structure from an adjacent nitride layer is formed by the foreign material, so that the corresponding region has different etching characteristics from the adjacent nitride layer.

Here, the term "foreign material" refers to a material different from a Group-III element that forms the lattice of the first nitride layer 210. The foreign material may be a material such as a Group-II, Group-III or Group-IV material, which can substitute for the Group-III element to form a lattice in a corresponding lattice structure.

The region doped with the foreign material has characteristics of the etch barrier 212 which is not well etched as compared with a nitride layer which is not doped with the foreign material during etching. Thus, during anisotropic etching, nano structures 213 having a constant size may be formed according to a pattern of the etch barriers 212, and the voids 214 having a uniform size may be formed from the nano structures 213.
Fig. 2 is a flowchart of a process of manufacturing the template of Fig. 1.

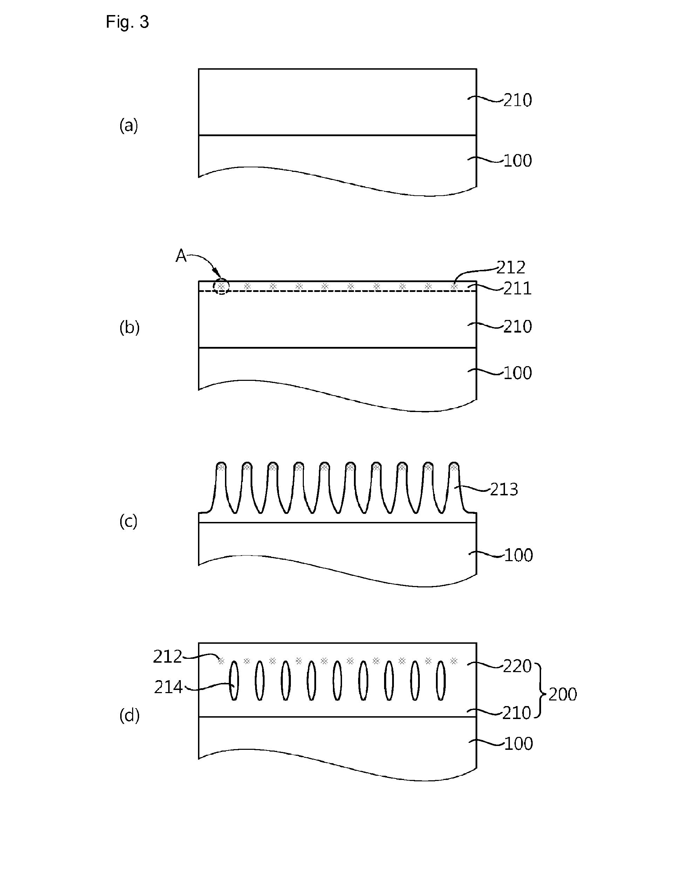

   Fig. 3 is a schematic sectional view explaining the process of manufacturing the template of Fig. 2. Hereinafter, the process for growing the nitride buffer layer will be described in detail with reference to Figs. 2 and 3.

As shown in Fig. 3 (a), a first nitride layer 210 is grown to a thickness of 0.2 to 10 µm on a sapphire substrate 100 in S10. This operation may be performed using a metal organic chemical vapor deposition (MOCVD) apparatus, hydride vapor phase epitaxy (HVPE) apparatus or molecular beam epitaxy (MBE) apparatus. In this embodiment, the MOCVD apparatus is used to ensure satisfactory growth of a lattice of the nitride layer.

The sapphire substrate 100 is placed inside the MOCVD apparatus, and trimethyl gallium (TMGa) and ammonia (NH₃) are supplied together with hydrogen (H₂) as a carrier gas into the MOCVD apparatus, thereby growing the first nitride layer 210 made of an undoped-GaN (u-GaN) material. In an initial stage of the growth process, a buffer is formed by growing a 20 nm u-GaN layer at a low temperature of 500 to 700°C for about 10 to 30 minutes, and the u-GaN layer is additionally grown to a thickness of about 2 µm by increasing the temperature up to 1,000 to 1,200°C. Accordingly, the first nitride layer is formed.

Then, operation of forming etch barriers on the first nitride layer is performed in S20. In this operation, trimethyl gallium (TMGa) and ammonia (NH₃) for growth of the u-GaN are supplied into the MOCVD apparatus as in the previous operation, and a process gas containing a foreign material is additionally supplied into the MOCVD apparatus. Thus, this operation is performed in-situ in the MOCVD apparatus, and may be performed consecutively with the operation of growing the first nitride layer.

In this embodiment, magnesium (Mg) is used as the foreign material, a nitride thin film 211 is grown by supplying a small amount of Cp₂Mg (bis-magnesium) together with trimethyl gallium (TMGa) and ammonia (NH₃) into the MOCVD apparatus. The magnesium atoms pyrolyzed in the Cp₂Mg form a lattice structure at a location of Ga in GaN lattice of the nitride thin film 211. Since magnesium atoms have an atomic radius greater than Ga atoms, deformation occurs not only in the corresponding lattice but also in a lattice structure adjacent to the corresponding lattice due to the doped magnesium atoms. Therefore, hexagonal hillrocks are formed in a predetermined pattern on a mirror-like smooth top surface of the nitride layer. As described above, an etch barrier 212 that is not properly etched in the etching process as compared with an adjacent nitride layer is formed at the region where the lattice structure is deformed by the doped foreign material.

Although this embodiment describes magnesium as the foreign material for forming the etch barrier, it should be understood that this is provided only as an example and the invention is not limited thereto. Alternatively, various elements such as Group-II, Group-III and Group-IV elements may be used as the foreign material. Advantageously, at least one selected from the group consisting of magnesium (Mg), indium (ln), aluminum (Al), and silicon (Si), which are used in growth of a nitride layer in a light emitting device, may be used so as to perform this operation in an in-situ manner.

After the etch barriers are formed on the first nitride layer as described above, an etching process is performed to form nano structures in S30. In the case where etching is consecutively performed in the MOCVD apparatus, the nitride layer with which the inner wall of a chamber is coated in the previous operation is etched, so that a large amount of particles can be produced. Accordingly, the etching process is performed in an ex-situ manner, for example, using the HVPE apparatus that mayprovide a high-temperature etching environment.

The substrate having the etch barriers on the first nitride layer is transferred from the MOCVD apparatus to the HVPE apparatus, and the internal temperature of the HVPE apparatus increases to 800°C or higher. Then, anisotropic etching is performed by supplying chloride-based gas and ammonia (NH₃) gas into the HVPE apparatus. In this embodiment, hydrogen chloride (HCl) is used as an example of the chloride-based gas. Here, the effect of etching the first nitride layer may be obtained even when supplying only the hydrogen chloride (HCl) or when supplying only the ammonia (NH₃) gas. However, the structure of the nitride layer at a portion where the etching is not performed may become unstable. Therefore, a mixture obtained by combining hydrogen chloride (HCl) gas in a range from 0 to 1,000 sccm and ammonia (NH₃) gas in a range from 100 to 2,000 sccm is preferably supplied to the inside of HVPE apparatus. In this embodiment, the etching process is performed by supplying the hydrogen chloride (HCl) gas of 300 sccm and the ammonia (NH₃) gas of 1,000 sccm.

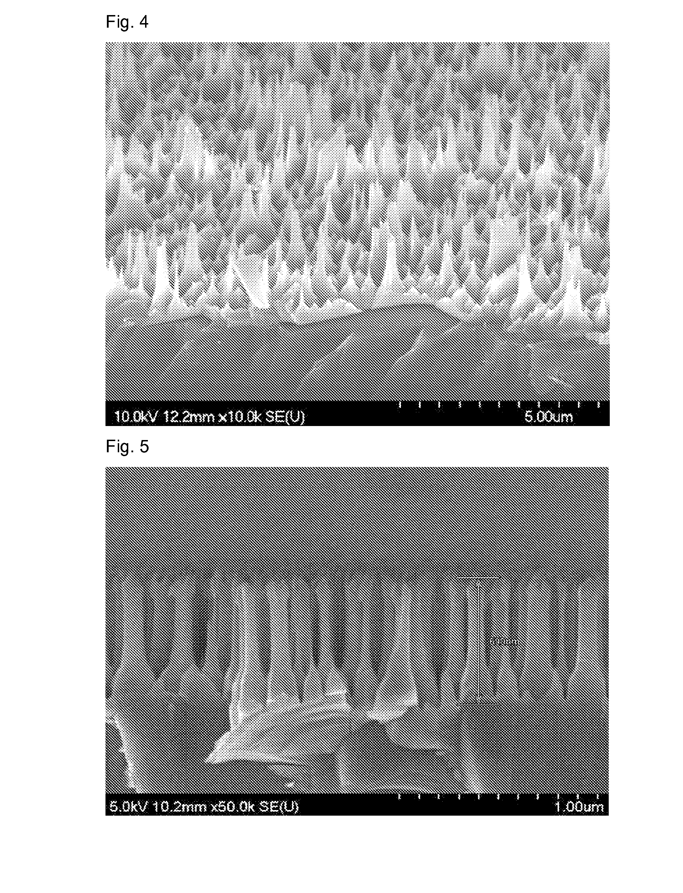

Fig. 4 is a scanning electron microscope (SEM) photograph showing a cross section of a first nitride layer obtained by performing an etching process for 15 minutes in a state in which no etch barrier is formed. Fig. 5 is an SEM photograph showing a section of a first nitride layer obtained by performing an etching process for 15 minutes in a state where an etch barriers are formed.

As shown in Figs. 4 and 5, as etching is carried out, a plurality of depressed valley structures is formed by downward anisotropic etching on top of the first nitride layer 210 and a plurality of nano structures 213 is formed at portions of the first nitride layer 210 at which etching is insufficiently performed (see Fig. 3(c)). Since etching is randomly performed on the top of the nitride layer in a state in which the etch barriers 212 are not formed, as shown in Fig. 4, the size and shape of the nano structures are very irregular. On the other hand, in the case where the etch barriers 212 are formed on the top of the nitride layer as in this embodiment, etching is performed at portions where the etch barriers are not positioned on the nitride layer, and the nano structures are formed at positions having the etch barriers 212 formed thereon, respectively (see Fig. 5).

When the nitride layer is etched using the etch barriers 212 as in this embodiment, it is possible to form the nano structures 213 in a constant size due to excellent etching selectivity for each position. If the nitride layer is etched without the etch barrier, the nano structure has a sharp end portion, thereby making it difficult to induce horizontal growth of a second nitride layer 220 (see Fig. 4). However, according to this embodiment, the end portion of the nano structure 213 has a rounded peak shape, so that voids can be easily formed by inducing horizontal growth of the second nitride layer 220.

After the nano structures are formed through the etching process, operation of cooling the first nitride layer 210 for a predetermined time is performed. The cooling operation is performed by natural cooling in the HVPE apparatus, and the first nitride layer 210 can be stabilized through this process. The cooling operation may be performed for 15 to 60 minutes. In this embodiment, natural cooling is performed for 30 minutes.

Subsequently, the substrate is transferred from the HVPE apparatus to the MOCVD apparatus to grow the second nitride layer 220. The second nitride layer may be grown in an apparatus other than the MOCVD apparatus. However, in this embodiment, the MOCVD apparatus is used so as to induce horizontal growth of the second nitride layer in the range of a few micrometers.

The substrate 100 is first placed inside the MOCVD apparatus, and the temperature of a process space is increased by driving a heater so as to form the growth environment of the second nitride layer 220. Ammonia (NH₃) gas may be continuously supplied to the MOCVD apparatus while increasing the temperature of the process space. As described above, since the ammonia (NH₃) gas is supplied to the MOCVD apparatus, it is possible to prevent cracks from occurring in the first nitride layer 210 previously grown during the increase of the temperature and to remove an oxide film that may be formed on the first nitride layer 210 in the operation of transferring the substrate.

If the temperature of the MOCVD apparatus is sufficiently increased, the second nitride layer 220 made of a GaN material is grown by supplying trimethyl gallium (TMGa) and ammonia (NH₃) together with hydrogen (H₂) as a carrier gas into the MOCVD apparatus (S40, see Fig. 3 (d)).

In an initial stage of the growth process of the second nitride layer 220, a relatively low-pressure and high-temperature environment may be formed as compared with a general GaN growth environment, thereby allowing horizontal growth to be performed at an upper portion of the nano structure 213. Thus, in this embodiment, the second nitride layer 220 is induced to form a roof structure by horizontally growing the GaN layer under an environment of a high temperature of 1,150 to 1,250 and a low pressure of 200 mb or lower in the initial stage of the second nitride layer 220. After the second nitride layer 200 forms the roof structure at the upper portion of the nano structure through horizontal growth, the GaN layer is vertically grown to 1 to 5 µm or so by setting the process environment to a temperature of 1,000 to 1,200°C and a pressure of 300 mb or higher. In this operation, specific process conditions may be modified by those skilled in the art, in consideration of the size of the nano structure 213, the size of a void 214 to be formed, or the like.

The nitride buffer layer 200 grown through the aforementioned processes has a structure in which a plurality of voids 214 is formed therein. Particularly, in the present invention, the nano structures having a constant height and an end portion with a round peak shape is used, such that it is possible to easily form a structure of the voids 214 and to provide voids 214 with a constant size and which are relatively uniformly distributed inside the nitride buffer layer 200.

The structure of the voids 214 can reduce stress caused by differences in lattice constant and thermal expansion coefficients between the nitride buffer and the sapphire substrate. Further, dislocations generated in the nitride layer adjacent to the substrate are eliminated by the structure of the voids, so that it is possible to prevent the dislocations from propagating toward the upper portion of the nitride layer.

Practically, as a result obtained by measuring the nitride buffer layer grown according to this embodiment, dislocations of 10⁶/cm² or so were measured even when the thickness of the nitride buffer layer was 2 to 4 µm, showing that dislocation density of the nitride buffer layer is decreased by 1 % or lower as compared with a conventional nitride buffer layer.

Thus, the template according to the present invention has a nitride buffer layer in which stress is reduced and a dislocation density is decreased, so that it is possible to grow nitride layers of a light emitting device, which has a satisfactory crystal quality on a top surface of the nitride buffer layer, and to manufacture a light emitting device, light emitting efficiency of which is improved by 30 to 40% as compared with the conventional light emitting device as an experimental result.

Meanwhile, the template according to the present invention may be manufactured using various methods in addition to the aforementioned embodiment.

In one embodiment, although the etch barriers are formed using one foreign material in the template according to the present invention, the etch barriers may be formed using two or more foreign materials. In this case, etching characteristics of the etch barriers vary depending on the kind of doped foreign material. Thus, it is possible to form nano structures having various sizes and various shapes of end portions in an etching process.

In another embodiment, although the etch barriers are formed in a random pattern by supplying a doping gas containing a foreign material in the template according to the present invention, the etch barriers may be formed at positions designed through a separate pattern forming apparatus using a mask or the like. In this case, the pattern of the etch barriers is controlled, so that it is possible to control the formation positions of nano structures and voids.

In still another embodiment, although the etch barriers are formed in a single layer on the same plane in the template according to the present invention, the etch barriers may be formed to have a multi-layered structure. For example, in the operation of forming the etch barriers, a first nitride thin film doped with magnesium is formed by supplying Cp₂Mg (bis magnesium) together with trimethyl gallium (TMGa) and ammonia (NH₃), and an undoped second nitride thin film is formed by stopping the supply of the Cp₂Mg (bis magnesium) for a predetermined period of time. Then, the supply of the Cp₂Mg (bis magnesium) is again performed, thereby forming the second nitride thin film doped with magnesium. In this case, nano structures having two types of heights may be formed through etching, and thus the shape of voids formed by the nano structures can be varied.

As described above, the etch barriers are formed in various shapes, so that it is possible to variously control the shapes, sizes and patterns of the nano structures and voids. Accordingly, it is possible to provide a template having a void structure desired by a user according to the use of the template.

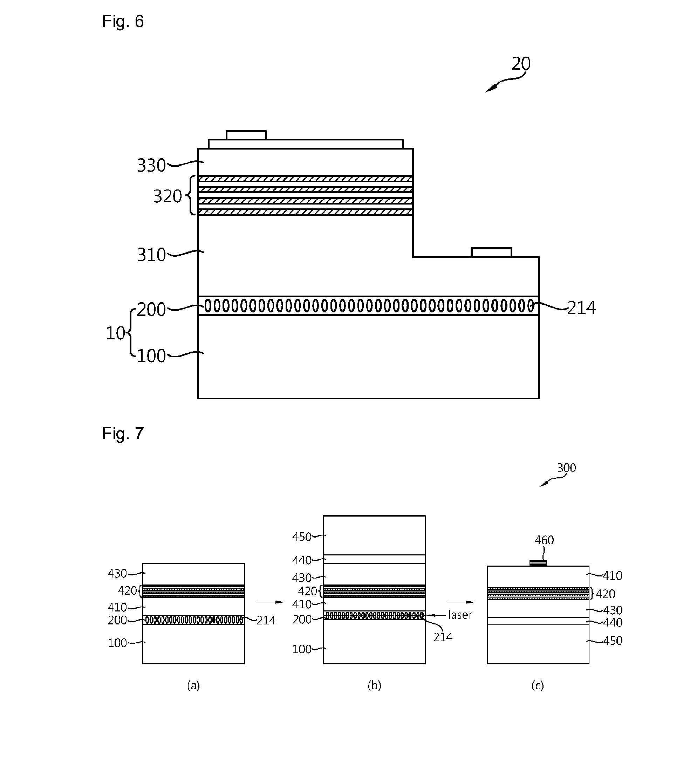

In the template according to the invention, nitride layers of the light emitting device can be grown on the top surface of the nitride buffer layer as described above. Fig. 6 is a sectional view of a lateral type nitride-based semiconductor according to an exemplary embodiment of the present invention.

As shown in Fig. 6, the vertical nitride-based semiconductor light emitting device 20 has a structure in which an n-type nitride layer 310, an active layer 320 and a p-type nitride layer 330 are sequentially stacked on a template 10. Thus, a nitride buffer layer 200 is grown in an MOCVD apparatus, and nitride layers of the light emitting device can be grown through consecutive processes.

In the case where first and second nitride layers 210 and 220 are grown using an undoped GaN material as described in this embodiment, the n-type nitride layer, the active layer and the p-type nitride layer are sequentially grown by growing the second nitride layer and then controlling temperature and process gas.

Alternately, after an etching process of the first nitride layer is performed, an n-type nitride layer may be grown as the second nitride layer, and an active layer and a p-type nitride layer may then be additionally grown on the n-type nitride layer.

As described above, in the lateral type nitride-based semiconductor light emitting device according to the present invention, a plurality of voids are formed in a nitride layer adjacent to a substrate 100, and hence the stress and dislocation density of the nitride layer is decreased. Thus, it is possible to improve internal quantum efficiency and to prevent polarization.

The voids have a different refractive index from an adjacent nitride layer. Thus, light propagating toward the substrate is scattered or refracted by passing through the plurality of voids, so that the path of the light is changed. Accordingly, it is possible to improve the light extraction efficiency of the light emitting device.

Meanwhile, the present invention can be used in a process of a vertical nitride-based semiconductor light emitting device. Fig. 7 schematically illustrates a method for manufacturing a vertical nitride-based light emitting device according to an exemplary embodiment of the invention.

Like the template manufacturing method as described above, an undoped nitride layer is grown on a growth substrate 100, and etch barriers are formed in a predetermined pattern, followed by an etching process to form nano structure. Then, a multi-layered nitride layer of the light emitting device is formed by sequentially growing an n-type nitride layer 410, an active layer 420 and a p-type nitride layer 430 directly on top of the nano structures formed by the etching process. A plurality of voids is disposed at a boundary between the undoped nitride layer and the n-type nitride layer (see Fig. 7 (a)).

After the growth of the multi-layered nitride layer is completed, a conductive adhesive layer 440 is formed on the p-type nitride layer 430 and a conductive substrate 450 is attached to the conductive adhesive layer 440. Here, the conductive substrate 450 is electrically connected to an external circuit so as to form a p-side electrode.

Then, operation of removing the growth substrate 100 from the nitride layers (see Fig. 7 (b)) is performed. Since the nitride buffer layer exists in the form of nano structures, a region having the plurality of voids 214 formed therein has a relatively weak structure, as compared with the other nitride layers. Thus, the growth substrate 100 can be easily separated from the nitride layers using the region of the plural voids 214 as a sacrificial surface.

A laser lift-off (LLO) process may be used to remove the substrate by irradiating a nitride layer adjacent to the growth substrate 100 with a laser. Conventionally, since a nitride layer constitutes a strong lattice structure, the nitride layer is seriously damaged upon laser irradiation, thereby lowering yield. However, according to the invention, the position having a relatively weak structure due to the plurality of voids 214 is irradiated with a laser, so that it is possible to minimize damage to the nitride layer.

In addition to the LLO process described above, the growth substrate 100 may be separated from the nitride layer by controlling the temperatures of the nitride layer and the growth substrate 100. Since there is a large difference in thermal expansion coefficient between the nitride layer and the growth substrate made of sapphire, cooling is performed from a high-temperature at which the nitride layer is formed on the growth substrate, so that large stress is generated in the nitride layer due to thermal deformation. In an experimental result, as the growth substrate is cooled, cracks occur along portions at which the plurality of voids are formed, and the growth substrate can be separated from the nitride layer by additionally providing a small amount of energy to these portions.

As described above, in the light emitting device according to the embodiments of invention, the growth substrate can be easily separated from the nitride layer based on the position at which the plural voids are formed. Further, since a change in stress applied to the nitride layer in the separation of the growth substrate is relatively small, it is possible to form a freestanding layer with satisfactory quality as compared with a conventional light emitting device.

Meanwhile, after the growth substrate 100 is separated, operation of processing a sacrificial surface to expose the n-type nitride layer 410 is performed to form an electrode pad 460. Conventionally, it is difficult to perform this operation while determining whether the n-type nitride layer 410 is exposed in processing the sacrificial surface. However, according to the present invention, since the sacrificial surface is formed at a boundary between the undoped nitride layer and the n-type nitride layer 410, this operation can be more easily performed.

As described above, it is possible to form a nitride layer with satisfactory quality and to provide a light emitting device having improved workability in manufacture of the light emitting device and excellent light emitting efficiency and durability.

As such, according to the embodiments, stress between lattices and dislocation defects can be reduced by a plurality of voids formed in an undoped nitride layer, thereby improving the quality of a nitride layer grown in a template.

Further, when a light emitting device is manufactured using the template, it is possible to improve workability of the manufacturing process and to enhance luminous efficacy of the light emitting device.

Although some embodiments have been described herein, it should be understood by those skilled in the art that these embodiments are given by way of illustration only, and that various modifications, variations, and alterations can be made without departing from the spirit and scope of the invention. Therefore, the scope of the invention should be limited only by the accompanying claims and equivalents thereof.

## Claims

1. A template including a nitride buffer layer, **characterized by** comprising:
a substrate; and
a nitride buffer layer formed on the substrate to have a structure of a plurality of voids,
wherein the nitride buffer layer comprises a first nitride layer forming a plurality of nano structures at an upper side thereof and a second nitride layer forming a roof structure on top of the plurality of nano structures, and a plurality of etch barriers having different etching characteristics from adjacent portions are formed at upper portions of the plurality of nano structures.

2. The template of claim 1, **characterized in that** the etch barriers are formed by doping the first nitride layer with a foreign material.

3. The template of claim 2, **characterized in that** the foreign material comprises at least one selected from the group consisting of indium (ln), aluminum (Al), magnesium (Mg), and silicon (Si).

4. A method for manufacturing a template including a nitride buffer layer, **characterized by** comprising:
growing a first nitride layer containing a Group-III material on a substrate;
forming a plurality of etch barriers having different etching characteristics from the first nitride layer on the first nitride layer;
forming a pillar-shaped nano structure by etching the first nitride layer in a pattern of the etch barriers using a chloride-based gas; and
forming a nitride buffer layer having a plurality of voids formed therein by growing a second nitride layer on top of the nano structure.

5. The method of claim 4, **characterized in that** the forming the etch barriers comprises growing a nitride layer doped with a foreign material, and the etch barriers are formed at positions of the nitride layer where the foreign material is doped.

6. The method of claim 5, **characterized in that** the nano structures are formed at the positions having the etch barriers formed thereon.

7. The method of claim 5, **characterized in that** the foreign material has an atomic radius greater than the Group-III material of the first nitride layer.

8. The method of claim 5, **characterized in that** the foreign material comprises at least one selected from the group consisting of indium (ln), aluminum (Al), magnesium (Mg) and silicon (Si).

9. The method of claim 4, **characterized in that** the forming the etch barriers is performed in-situ after the first nitride layer is grown.

10. The method of claim 4, **characterized in that** the growing the first nitride layer comprises supplying a plurality of process gases to top of the substrate, and the forming the etch barriers comprises additionally supplying a doping gas containing the foreign material together with the plurality of process gases, and the forming the etch barriers is performed as a consecutive process with the growing the first nitride layer.

11. The method of claim 4, **characterized in that** the forming the etch barriers comprises:
growing a first nitride thin film doped with the foreign material;
growing a second nitride thin film undoped with the foreign material; and
growing a third nitride thin film doped with the foreign material.

12. A method for manufacturing a vertical nitride-based light emitting device using a template including a nitride multi-layered, **characterized by** comprising:
growing an undoped nitride layer on a growth substrate, the undoped nitride layer having etch barriers formed therein;
forming a pillar-shaped nano structure by etching the undoped nitride layer in a pattern of the etch barriers using a chloride-based gas;
forming a multi-layered nitride layer having a plurality of voids formed therein by growing an n-type nitride layer, an active layer and a p-type nitride layer on top of the nano structure;
forming a conductive substrate on top of the multi-layered nitride layer;
removing the growth substrate using a portion having the plurality of voids formed therein as a cutting surface; and
processing the cutting surface to form an electrode pad.

13. The method of claim 12, **characterized in that** the etch barriers are formed by the foreign material with which a top of the undoped nitride layer is doped, and the etch barriers have different etching characteristics from the adjacent undoped nitride layer at a position where the undoped nitride layer is doped with the foreign material.

14. The method of claim 13, **characterized in that** the removing the growth substrate comprises irradiating the portion having the plurality of voids formed therein with a laser to remove the growth substrate.

15. The method of claim 13, **characterized in that** the removing the growth substrate comprises cooling the multi-layered nitride layer to induce cracks at the portion having the plurality of voids formed therein.
